# EUROPEAN PATENT APPLICATION

(11) **EP 4 020 564 A1**
(43) Date of publication of application: **29.06.2022**
(21) Application number: 21210284.2
(22) Date of filing: 24.11.2021
(51) Int. Cl.: H01L 27/12, H01L 27/06

(54) **NOVEL METHOD TO FORM SINGLE CRYSTAL MOSFET AND FEFET**

(30) Priority: 23.12.2020 US 202017132996
(71) Applicant: INTEL Corporation, Santa Clara, CA 95054 (US)
(72) Inventor: MAJHI, Prashant, San Jose, 95121 (US); SHARMA, Abhishek Anil, Portland, 97229 (US); Kuo, Charles, Hillsboro, 97124 (US); DOYLE, Brian S., Portland, 97229 (US); ALAAN, Urusa, Hilsboro, 97124 (US); Le, Van, Beaverton, 97007 (US); Karpov, Elijah V., Portland, 97229 (US); OGUZ, Kaan, Portland, 97229 (US); SEN GUPTA, Arnab, Beaverton, 97003 (US)
(74) Representative: 2SPL Patentanwälte PartG mbB

(57) **Abstract**

Embodiments disclosed herein include a semiconductor devices with back end of line (BEOL) transistor devices. In an embodiment, a semiconductor device comprises a semiconductor substrate and a BEOL stack over the semiconductor substrate. In an embodiment, a field effect transistor (FET) is embedded in the BEOL stack. In an embodiment, the FET comprises a channel, a gate dielectric over the channel, where the gate dielectric is single crystalline, a gate electrode over the gate dielectric, and a source electrode and a drain electrode passing through the gate dielectric to contact the channel.

## Description

### TECHNICAL FIELD

Embodiments of the disclosure are in the field of semiconductor structures and processing and, in particular, to MOSFET and FeFET devices formed in the back end of line (BEOL) stack that include single crystalline gate dielectrics.

### BACKGROUND

Alongside scaling metal-oxide-semiconductor field-effect transistors (MOSFETs) on the semiconductor substrate, it is becoming increasingly advantageous to integrate high quality MOSFETs in the backend (i.e., back end of line (BEOL)) of traditional complementary metal oxide semiconductor (CMOS) devices for logic and memory applications. Given this desire, it is challenging to form high quality channel materials (e.g., silicon, etc.) as well as high quality dielectrics to realize high performance MOSFETs with acceptable variability and reliability. Furthermore, for some devices (such as HfO₂ based ferroelectric FETs (FeFETs)), the properties of the devices are significantly degraded due to the poly crystalline nature of the gate (ferroelectric) stack.

In HfO₂ based FeFETs, there are significant challenges that stem from the presence of a polycrystalline HfO₂ crystal structure. To begin with, only some of the grains are orthorhombic phase (i.e., the ferroelectric phase). Of those grains, only a subset are properly aligned to the applied (gate-channel) field direction. This causes significant variability in the FeFETs that limits the potential of these high scaled memory devices that are also high performance and non-volatile. The variability limits the usefulness of such FeFETs and does not allow for integration in large memory arrays.

### BRIEF DESCRIPTION OF THE DRAWINGS

Figure 1 is a cross-sectional illustration of a polycrystalline gate dielectric between a gate electrode and a channel.
Figure 2A is a cross-sectional illustration of a single crystalline gate dielectric grown over a template layer, in accordance with an embodiment.
Figure 2B is an x-ray diffraction (XRD) graph of the gate dielectric showing the crystallinity, in accordance with an embodiment.
Figure 3A is a cross-sectional illustration of a template layer with an embedded release layer, in accordance with an embodiment.
Figure 3B is a schematic of the release of a top portion of the template layer from a bottom portion of the template layer, in accordance with an embodiment.
Figure 4A is a cross-sectional illustration of a stack comprising a template layer, a single crystalline dielectric, and a semiconductor channel provided over a first substrate, in accordance with an embodiment.
Figure 4B is a cross-sectional illustration of the stack after a portion is released from the first substrate, in accordance with an embodiment.
Figure 4C is a cross-sectional illustration depicting the released stack being adhered to a back end layer of a second substrate, in accordance with an embodiment.
Figure 4D is a cross-sectional illustration of the released stack on the second substrate, in accordance with an embodiment.
Figure 4E is a cross-sectional illustration after the template layer is removed to expose the single crystalline dielectric, in accordance with an embodiment.
Figure 4F is a cross-sectional illustration after a gate electrode and source/drain electrodes are formed to provide a transistor device, in accordance with an embodiment.
Figure 5 illustrates a computing device in accordance with one implementation of an embodiment of the disclosure.
Figure 6 is an interposer implementing one or more embodiments of the disclosure.

### DESCRIPTION OF THE EMBODIMENTS

Embodiments described herein comprise MOSFET and FeFET devices formed in the back end of line (BEOL) stack that include single crystalline gate dielectrics. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

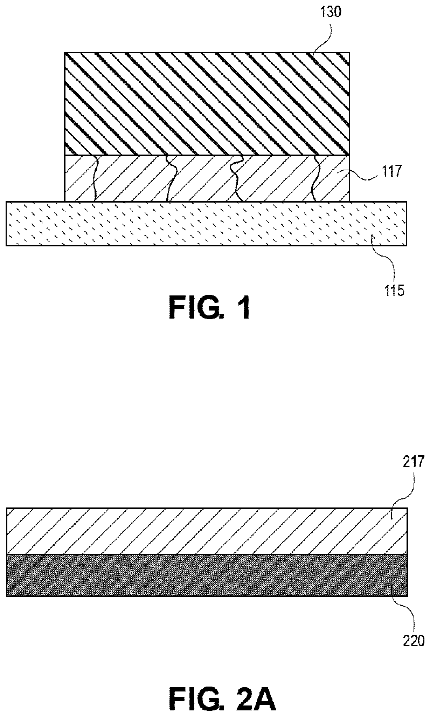

To provide context, a back end of line (BEOL) gate stack is shown in Figure 1. As shown, a gate dielectric 117 is provided over a semiconductor channel layer 115. A gate electrode 130 is provided over the gate dielectric 117. As indicated by the various lines through the gate dielectric 117, the gate dielectric 117 is a polycrystalline material. The polycrystalline crystal structure is formed due, in part, to the limitations of material deposition in the back end. For example, low temperatures are needed in order to not damage the BEOL materials. Additionally, there is no underlying single crystalline template onto which the gate dielectric 117 can be grown with an orthorhombic phase. Additionally, the orthorhombic phase cannot be nucleated from its amorphous state to exhibit epitaxial registry with the channel 115 or the gate electrode 130. As noted above, the polycrystalline nature of the gate dielectric 117 results in high variability in the transistor device. This causes significant variability in the transistors that limits the potential of these high scaled memory devices. Particularly, the variability limits the usefulness of such transistors and does not allow for integration in large memory arrays.

Accordingly, embodiments disclosed herein include a single crystalline gate dielectric. The single crystalline structure has the ferroelectric phase (e.g., orthorhombic for HfO₂) that is properly oriented in order to provide a strong ferroelectric effect for the transistor. Additionally, since there is a single crystal, the variability is greatly reduced. The reduction in variability also enables significant improvement in power performance area cost (PPAC). For example, a transistor can be made to operate in V/2 inhibit scheme and the Vmax can be lower due to reduced variability.

In an embodiment, the orthorhombic single phase crystal structure is provided by epitaxially growing the gate dielectric on a template layer. The template layer may be a single crystalline material with an orthorhombic crystal structure. After growth of the gate dielectric, a semiconductor channel is epitaxially grown over the gate dielectric. The template layer may have an embedded release layer. After growth of the gate dielectric and the semiconductor channel, the top portion of the template layer is released from the bottom portion of the template layer. The released stack may then be attached to a device substrate. In a particular embodiment, the released stack is attached to the BEOL stack of the device substrate.

Referring now to Figure 2A, a cross-sectional illustration of a template layer 220 and a gate dielectric 217 is shown, in accordance with an embodiment. In an embodiment, the gate dielectric 217 is epitaxially grown over the template layer 220. The template layer 220 may comprise a material with a single crystalline orthorhombic crystal structure. For example the template layer 220 may comprise strontium titanate (STO) or indium tin oxide (ITO). The template layer 220 may be provided over an underlying substrate (not shown) such as a silicon substrate or the like. In an embodiment, the gate dielectric 217 also includes a single crystalline orthorhombic crystal structure. For example, the gate dielectric 217 may comprise HfO₂, though other ferroelectric dielectrics may also be used. In a particular embodiment, the gate dielectric 217 may comprise a yttrium doped HfO₂.

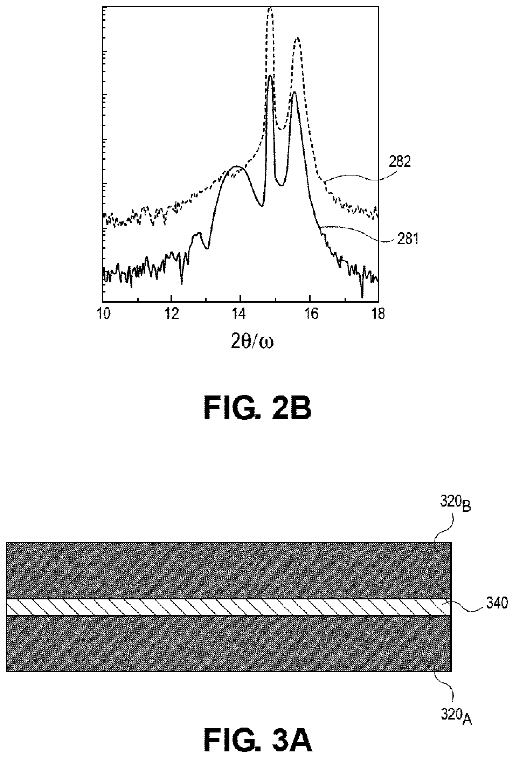

Referring now to Figure 2B, an x-ray diffraction (XRD) plot of the template layer 220 and the gate dielectric 217 are shown. The line 282 is the plot of the template layer 220, and the line 281 is the plot of the gate dielectric 217. As illustrated, the peaks of the template layer 220 substantially coincide with the peaks of the gate dielectric 217. This shows good registry between the two layers and indicates that a single crystalline crystal structure is provided in the gate dielectric 217.

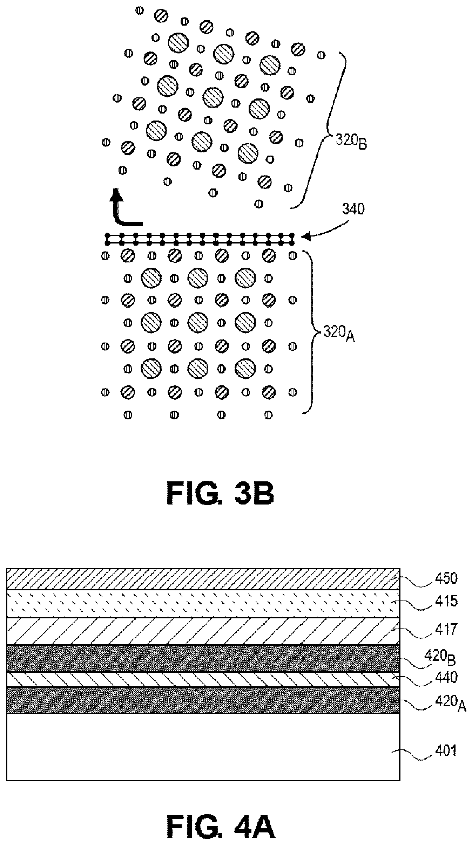

Since the gate dielectric 217 is grown on the template layer 220, there needs to be a mechanism to release the gate dielectric 217 so it can be attached to a device substrate. One such mechanism is illustrated in Figures 3A and 3B. As shown in Figure 3A, the template layer 320 comprises a bottom portion 320_{A} and a top portion 320_{B}. The bottom portion 320_{A} is separated from the top portion 320_{B} by a release layer 340. The release layer 340 may be any material that allows for separation of the top portion 320_{B} from the bottom portion 320_{A}. For example, the release layer 340 may comprise graphene or other epitaxial oxides. In an embodiment, the release mechanism may include a laser process, a thermal process, or the like. As shown in the schematic of Figure 3B, the top portion 320_{B} can be peeled away from the release layer 340.

Referring now to Figures 4A-4F, a series of cross-sectional illustrations depicting a process for forming a FeFET is shown, in accordance with an embodiment.

Referring now to Figure 4A a cross-sectional illustration of a layer stack is shown, in accordance with an embodiment. In an embodiment, the layer stack may be formed over a substrate 401. For example, the substrate 401 may comprise a semiconductor substrate, such as silicon. In an embodiment, a template layer 420 is grown over the substrate 401. The template layer 420 may comprise a bottom portion 420_{A} and a top portion 420_{B}. In an embodiment, a release layer 440 is embedded in the template layer 420 between the top portion 420_{B} and the bottom portion 420_{A}. The template layer 420 may comprise a single crystalline template material, such as, but not limited to ITO or STO. The release layer 440 may comprise graphene or another epitaxial oxide.

In an embodiment, a gate dielectric 417 is epitaxially grown over the top portion 420_{B} of the template layer 420. The gate dielectric 417 is able to be grown with a single crystalline crystal structure. For example, the gate dielectric 417 may comprise an orthorhombic crystal structure. It is to be appreciated that the epitaxial growth conditions (e.g., temperature, etc.) used for the gate dielectric 417 are not limited by the surrounding material layers, as is the case when a gate dielectric 417 is formed directly in the BEOL stack. As such, the growth conditions for the gate dielectric 417 can be optimized to provide a high quality single crystalline orthorhombic crystal structure. In an embodiment, the gate dielectric 417 may be HfO₂, though other ferroelectric dielectric materials may also be used for the gate dielectric 417.

In an embodiment, the stack may further comprise a semiconductor channel 415 disposed over the gate dielectric 417. The semiconductor channel 415 may also be grown with an epitaxial process. As such, the semiconductor channel 415 may be single crystalline as well. In an embodiment, the semiconductor channel 415 comprises silicon. However, it is to be appreciated that other semiconductor materials may also be used for the semiconductor channel 415, such as, but not limited to, germanium, other group III-V semiconductors, and oxide semiconductors.

In an embodiment, an encapsulation layer 450 may be provided over the semiconductor channel 415. The encapsulation layer 450 may be an oxide or the like. The encapsulation layer 450 protects the semiconductor channel 415 and may serve to electrically isolate the semiconductor channel 415 after it is attached to the active device in a subsequent processing operation.

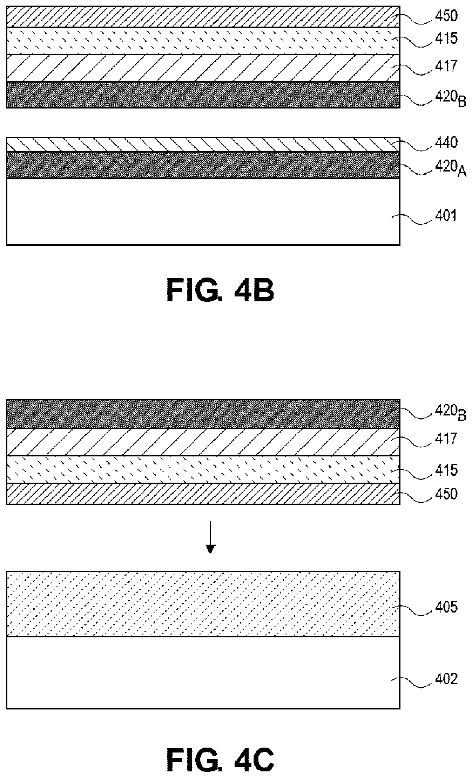

Referring now to Figure 4B, a cross-sectional illustration of the stack after the top portion 420_{B} is released from the bottom portion 420_{A} is shown, in accordance with an embodiment. The top portion 420_{B} may be released by a laser or thermal process that weakens the bond between the top portion 420_{B} of the template layer 420 and the release layer 440. As indicated, the released stack (e.g., the top portion 420_{B}, the gate dielectric 417, the semiconductor channel 415, and the encapsulation layer 450) may be lifted off of the substrate 401.

Referring now to Figure 4C, a cross-sectional illustration of the stack after the released stack is flipped upside down and brought towards a device substrate 402 is shown, in accordance with an embodiment. As indicated by the arrow, the encapsulation layer 450 is brought down onto a BEOL stack 405 over the device substrate 402. The device substrate 402 may comprise a semiconductor substrate, such as, but not limited to, a silicon substrate, a germanium substrate, or other group III-V semiconductor substrates. Transistors and the like (not shown) may be fabricated on the device substrate 402. The BEOL stack 405 provides conductive routing (not shown) to the transistors and other devices on the device substrate 402. It is to be appreciated that the released stack may be attached over the first metal layer (e.g., M0), or any metal layer of the BEOL stack 405. In some embodiments, the released stack may be attached directly to the device substrate 402 without an intervening BEOL stack 405.

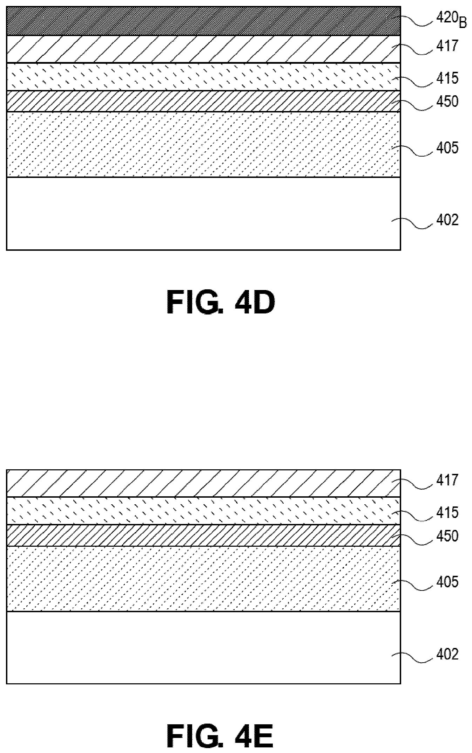

While the portion of the stack is shown as being released from the substrate 401 prior to attachment to the device substrate 402, in other embodiments, the entire stack (e.g., the substrate 401, the bottom portion 420_{B}, the release layer 440, the top portion 420_{A}, the gate dielectric 417, the semiconductor channel 415, and the encapsulation layer 450) may be bonded to the device substrate 402. In such an embodiment, the release layer 440 may be activated after attachment to the device substrate 402 in order to provide the structure shown in Figure 4E.

Referring now to Figure 4D, a cross-sectional illustration of the released stack attached to the device substrate 402 is shown, in accordance with an embodiment. The encapsulation layer 450 may be secured to the BEOL stack 405. For example, the material of the encapsulation layer 450 may serve as an adhesive to couple the two structure together. In other embodiments, a discrete bonding layer (not shown) may be provided between the encapsulation layer 450 and the BEOL stack 405.

Referring now to Figure 4E, a cross-sectional illustration of the structure after the top portion 420_{B} of the template layer 420 is removed is shown, in accordance with an embodiment. Removal of the top portion 420_{B} of the template layer 420 may be implemented with an etching process or a polishing process (e.g., chemical mechanical planarization (CMP)). Removal of the top portion 420_{B} exposes the gate dielectric 417.

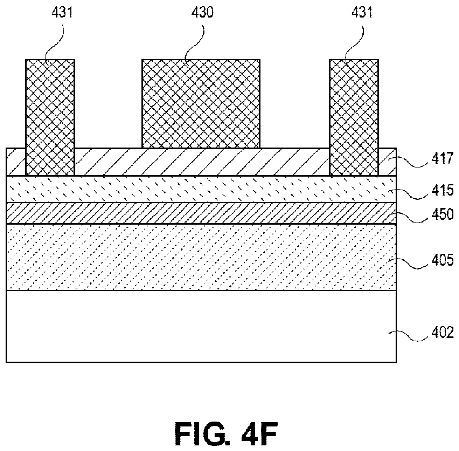

Referring now to Figure 4F, a cross-sectional illustration of the structure after gate and source/drain electrodes are formed is shown, in accordance with an embodiment. In an embodiment, the gate electrode 430 may be over and directly contacting a top surface of the gate dielectric 417. In an embodiment, the source/drain electrodes 431 may pass through a thickness of the gate dielectric 417 in order to contact a top surface of the semiconductor channel 415. That is, the source/drain electrodes 431 may also contact portions of the gate dielectric 417 as they pass through the thickness of the gate dielectric 417.

In an embodiment, the resulting FeFET structure may comprise any suitable dimensions for integration into the BEOL of the device substrate 402. For example, a footprint of the FeFET structure may be approximately 100nm × 100nm or smaller. Additionally, while one FeFET structure is shown in Figure 4F, it is to be appreciated that a plurality of FeFET structures in the BEOL of the device substrate 402 may be formed substantially in parallel. In a particular embodiment, the FeFET structure is part of a memory cell, and multiple memory cells may be provided to form a memory array in the BEOL of the device substrate 402.

While the FeFET structure is shown as being provided in the BEOL, it is to be appreciated that embodiments are not limited to such configurations. For example, a similar single crystalline gate dielectric may be formed on a template layer similar to the process described above. Instead of forming a semiconductor layer over the gate dielectric, the stack can be bonded to the front end (i.e., the semiconductor material). The template layer and any other underlying layers can then be released using a release layer similar to release layer 440. The residual portion of the release layer may then be removed, and a gate electrode and source and drain electrodes can be provided for the FeFET structure.

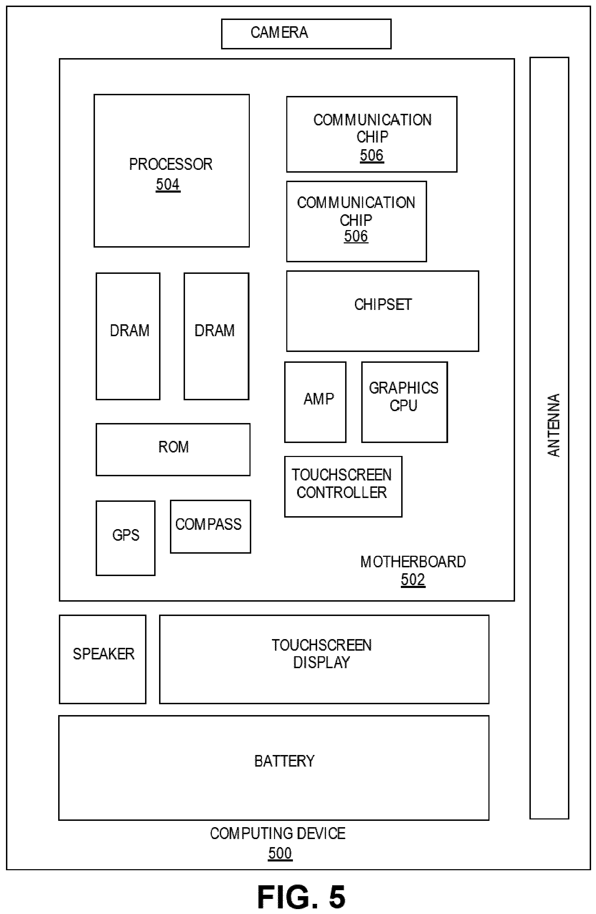

Figure 5 illustrates a computing device 500 in accordance with one implementation of an embodiment of the disclosure. The computing device 500 houses a board 502. The board 502 may include a number of components, including but not limited to a processor 504 and at least one communication chip 506. The processor 504 is physically and electrically coupled to the board 502. In some implementations the at least one communication chip 506 is also physically and electrically coupled to the board 502. In further implementations, the communication chip 506 is part of the processor 504.

Depending on its applications, computing device 500 may include other components that may or may not be physically and electrically coupled to the board 502. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 506 enables wireless communications for the transfer of data to and from the computing device 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing device 500 includes an integrated circuit die packaged within the processor 504. In an embodiment, the integrated circuit die of the processor may comprise an FeFET device provided in the BEOL stack, where the FeFET device comprises a single crystalline orthorhombic gate dielectric, as described herein. The term "processor" may refer to any device or portion of a device that processes electronic data from registers and/or memory to transform that electronic data into other electronic data that may be stored in registers and/or memory.

The communication chip 506 also includes an integrated circuit die packaged within the communication chip 506. In an embodiment, the integrated circuit die of the communication chip may comprise an FeFET device provided in the BEOL stack, where the FeFET device comprises a single crystalline orthorhombic gate dielectric, as described herein.

In further implementations, another component housed within the computing device 500 may comprise an FeFET device provided in the BEOL stack, where the FeFET device comprises a single crystalline orthorhombic gate dielectric, as described herein.

In various implementations, the computing device 500 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 500 may be any other electronic device that processes data.

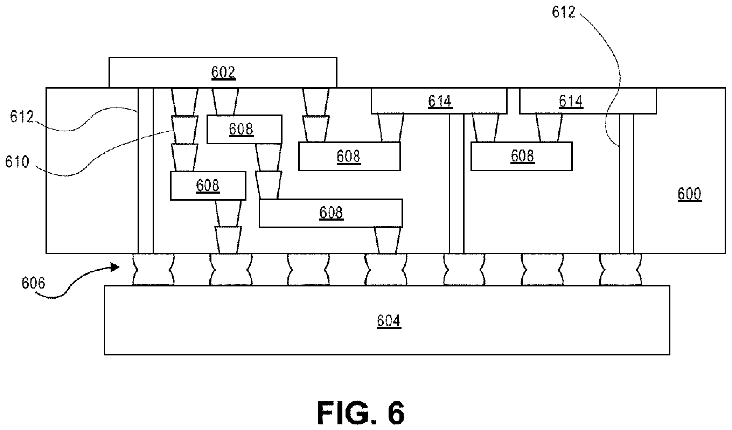

Figure 6 illustrates an interposer 600 that includes one or more embodiments of the disclosure. The interposer 600 is an intervening substrate used to bridge a first substrate 602 to a second substrate 604. The first substrate 602 may be, for instance, an integrated circuit die. The second substrate 604 may be, for instance, a memory module, a computer motherboard, or another integrated circuit die. In an embodiment, one of both of the first substrate 602 and the second substrate 604 may comprise an FeFET device provided in the BEOL stack, where the FeFET device comprises a single crystalline orthorhombic gate dielectric, in accordance with embodiments described herein. Generally, the purpose of an interposer 600 is to spread a connection to a wider pitch or to reroute a connection to a different connection. For example, an interposer 600 may couple an integrated circuit die to a ball grid array (BGA) 606 that can subsequently be coupled to the second substrate 604. In some embodiments, the first and second substrates 602/604 are attached to opposing sides of the interposer 600. In other embodiments, the first and second substrates 602/604 are attached to the same side of the interposer 600. And in further embodiments, three or more substrates are interconnected by way of the interposer 600.

The interposer 600 may be formed of an epoxy resin, a fiberglass-reinforced epoxy resin, a ceramic material, or a polymer material such as polyimide. In further implementations, the interposer 600 may be formed of alternate rigid or flexible materials that may include the same materials described above for use in a semiconductor substrate, such as silicon, germanium, and other group III-V and group IV materials.

The interposer 600 may include metal interconnects 608 and vias 610, including but not limited to through-silicon vias (TSVs) 612. The interposer 600 may further include embedded devices 614, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 600. In accordance with embodiments of the disclosure, apparatuses or processes disclosed herein may be used in the fabrication of interposer 600.

Thus, embodiments of the present disclosure may comprise an FeFET device provided in the BEOL stack ,where the FeFET device comprises a single crystalline orthorhombic gate dielectric.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.
Example 1: a semiconductor device, comprising: a semiconductor substrate; a back end of line (BEOL) stack over the semiconductor substrate; a field effect transistor (FET) embedded in the BEOL stack, wherein the FET comprises: a channel; a gate dielectric over the channel, wherein the gate dielectric is single crystalline; a gate electrode over the gate dielectric; and a source electrode and a drain electrode passing through the gate dielectric to contact the channel.
Example 2: the semiconductor device of Example 1, further comprising: an encapsulation layer between the channel and the semiconductor substrate.
Example 3: the semiconductor device of Example 1 or Example 2, wherein the gate dielectric comprises hafnium and oxygen.
Example 4: the semiconductor device of Examples 1-3, wherein the FET is above a first metal layer and a second metal layer in the BEOL stack.
Example 5: the semiconductor device of Examples 1-4, wherein the channel comprises silicon or germanium.
Example 6: the semiconductor device of Examples 1-4, wherein the channel comprises a semiconductor oxide.
Example 7: the semiconductor device of Examples 1-6, wherein a footprint of the FET is approximately 100nm × 100nm or smaller.
Example 8: the semiconductor device of Examples 1-7, wherein the FET is part of a memory cell.
Example 9: a method of forming a semiconductor device, comprising: forming a first layer on a substrate; forming a release layer over the first layer; forming a second layer over the release layer, wherein the second layer comprises the same material as the first layer; forming a gate dielectric over the second layer, wherein the gate dielectric is single crystalline; forming a semiconductor channel over the gate dielectric; separating the second layer, the gate dielectric, and the semiconductor channel from the first layer to form a released stack; and attaching the released stack to the semiconductor device.
Example 10: the method of Example 9, wherein the released stack is attached to a back end of line (BEOL) layer of the semiconductor device.
Example 11: the method of Example 9 or Example 10, wherein separating the released stack is done by a laser treatment.
Example 12: the method of Examples 9 or Example 10, wherein separating the released stack is done by a thermal treatment.
Example 13: the method of Examples 9-12, further comprising: removing the second layer from the gate dielectric after attaching the released stack to the semiconductor device.
Example 14: the method of Examples 9-13, wherein the first layer and the second layer comprise strontium titanate (STO).
Example 15: the method of Examples 9-13, wherein the first layer and the second layer comprise indium tin oxide (ITO).
Example 16: the method of Examples 9-15, wherein the gate dielectric comprises hafnium and oxygen.
Example 17: the method of Example 16, wherein the gate dielectric comprises an orthorhombic crystal structure.
Example 18: the method of Examples 9-17, further comprising: forming a gate electrode over the gate dielectric; and forming a source electrode and a drain electrode through the gate dielectric, wherein the source electrode and the drain electrode contact the semiconductor channel.
Example 19: an electronic system, comprising: a board; a package substrate attached to the board; and a die attached to the package substrate, wherein the die comprises: a back end of line (BEOL) field effect transistor (FET), comprising: a semiconductor channel; a gate dielectric over the semiconductor channel, wherein the gate dielectric comprises a single crystalline orthorhombic crystal structure; a gate electrode over the gate dielectric; and a source electrode and a drain electrode passing through the gate dielectric and contacting the semiconductor channel.
Example 20: the electronic system of Example 19, wherein the gate dielectric comprises hafnium and oxygen.

## Claims

1. A semiconductor device, comprising:
a semiconductor substrate;
a back end of line (BEOL) stack over the semiconductor substrate;
a field effect transistor (FET) embedded in the BEOL stack, wherein the FET comprises:
a channel;
a gate dielectric over the channel, wherein the gate dielectric is single crystalline;
a gate electrode over the gate dielectric; and
a source electrode and a drain electrode passing through the gate dielectric to contact the channel.

2. The semiconductor device of claim 1, further comprising:
an encapsulation layer between the channel and the semiconductor substrate.

3. The semiconductor device of claim 1 or 2, wherein the gate dielectric comprises hafnium and oxygen.

4. The semiconductor device of claim 1, 2 or 3, wherein the FET is above a first metal layer and a second metal layer in the BEOL stack.

5. The semiconductor device of claim 1, 2, 3 or 4, wherein the channel comprises silicon or germanium.

6. The semiconductor device of claim 1, 2, 3 or 4, wherein the channel comprises a semiconductor oxide.

7. The semiconductor device of claim 1, 2, 3, 4, 5 or 6, wherein a footprint of the FET is approximately 100nm × 100nm or smaller.

8. The semiconductor device of claim 1, 2, 3, 4, 5, 6 or 7, wherein the FET is part of a memory cell.

9. A method of forming a semiconductor device, comprising:
forming a first layer on a substrate;
forming a release layer over the first layer;
forming a second layer over the release layer, wherein the second layer comprises the same material as the first layer;
forming a gate dielectric over the second layer, wherein the gate dielectric is single crystalline;
forming a semiconductor channel over the gate dielectric;
separating the second layer, the gate dielectric, and the semiconductor channel from the first layer to form a released stack; and
attaching the released stack to the semiconductor device.

10. The method of claim 9, wherein the released stack is attached to a back end of line (BEOL) layer of the semiconductor device.

11. The method of claim 9 or 10, wherein separating the released stack is done by a laser treatment.

12. The method of claim 9 or 10, wherein separating the released stack is done by a thermal treatment.

13. The method of claim 9, 10, 11 or 12, further comprising:
removing the second layer from the gate dielectric after attaching the released stack to the semiconductor device.

14. The method of claim 9, 10, 11, 12 or 13, wherein the first layer and the second layer comprise strontium titanate (STO).

15. The method of claim 9, 10, 11, 12 or 13, wherein the first layer and the second layer comprise indium tin oxide (ITO).
